# EUROPÄISCHE PATENTSCHRIFT

(11) **EP 1 358 501 B1**
(45) Veröffentlichungstag und Bekanntmachung des Hinweises auf die Patenterteilung: **06.08.2008**
(21) Anmeldenummer: 02708198.3
(22) Anmeldetag: 02.02.2002
(51) Int. Cl.: G01R 33/035

(54) **RF-SQUID MAGNETOMETER**
RF-SQUID MAGNETOMETER
MAGNETOMETRE A SQUID RF

(30) Priorität: 07.02.2001 DE 10105796
(43) Veröffentlichungstag der Anmeldung: 05.11.2003
(73) Patentinhaber: Forschungszentrum Jülich GmbH, 52425 Jülich (DE)
(72) Erfinder: ZHANG, Yi, 52428 Jülich (DE); WOLTERS, Norbert, 52134 Herzogenrath (DE); BANZET, Marko, 52511 Geilenkirchen (DE); ZANDER, Willi, 52457 Aldenhoven (DE); SCHUBERT, Jürgen, 50189 Elsdorf (DE)
(86) Internationale Anmeldenummer: PCT/DE2002/000385
(87) Internationale Veröffentlichungsnummer: WO 2002/063324

(56) Entgegenhaltungen:
- EP-A- 1 160 972
- DE-A- 19 517 399
- PATENT ABSTRACTS OF JAPAN vol. 014, no. 124 (P-1018), 8. März 1990 (1990-03-08) & JP 01 318981 A (SHIMADZU CORP), 25. Dezember 1989 (1989-12-25)
- LEITE E R ET AL: "Microstructure and phase evolution of SrTiO3 thin films on Si prepared by the use of polymeric precursors" MATERIALS LETTERS, NORTH HOLLAND PUBLISHING COMPANY. AMSTERDAM, NL, Bd. 31, Nr. 3-6, Juni 1997 (1997-06), Seiten 173-178, XP004336508 ISSN: 0167-577X

## Beschreibung

Die Erfindung betrifft ein rf-SQUID-Magnetometer zum Messen von magnetischen Flüssen. Ein dc-SQUID ist aus JP01318981A bekannt.

### Stand der Technik

### I. Der rf-SQUID

Ein rf-SQUID (radio frequency superconducting quantum interference device) besteht aus einem supraleitenden Ring, der durch einen Josephson-Kontakt unterbrochen ist. Der rf-SQUID wird mit einem Schwingkreis induktiv gekoppelt. Die Koppelung zwischen SQUID und Schwingkreis Wird als *k²* bezeichnet. Der Schwingkreis ist durch die Resonanzfrequenz fₒ und den Gütefaktor Q charakterisiert. Wird ein rf-Strom mit fₒ in den Schwingkreis eingeprägt, fällt eine rf-Spannung über diesen ab. Diese Spannung wird von einem äußeren magnetischen Feld periodisch moduliert.

### II. YBCO Dünnschicht rf-SQUIDs und Substrate

Die Reduktion des Rauschens ist die wichtigste Arbeit in den SQUID Entwicklungen. Ein SQUID, der aus einer dünnen YBCO Schicht hergestellt wird, zeigt wesentlich weniger Rauschen als ein SQUID. aus YBCO-bulk Material. Typischerweise läßt man daher eine dünne YBCO-Schicht mit einer Dicke von ca. 200 nm auf einem Substrat epitaktisch einkristallin aufwachsen. Die Kristallstruktur des Substrats muß dabei gleich oder ähnlich wie die des YBCO-Supraleiters sein. Die am häufigsten benutzten Substrate für die SQUID-Herstellung sind deswegen LaAl0₃(100) und SrTi0₃(100). Die Dimensionen der Substrate sind normalerweise 10x10x1 mm³. Die modernen HTSL Dünnschicht-SQUIDs werden dann auf dem Substrat strukturiert, wobei das üblicherweise verwendete Layout des rf-SQUIDs der sogenannte "Washer" SQUID ist.

### III. Der "Koplanar-Resonator"

Seit 10 Jahren werden verschiedene Konfigurationen in der Dünnschicht-Technologie für die rf-SQUID Operation entwickelt. Eine erfolgversprechende Ausführung stellt die sogenannte Koplanar-Resonator Konfiguration dar. Der Koplanar-Resonator besteht aus zwei supraleitenden Mikroschleifen, die sich um den SQUID-Washer auf einem LaA10₃ Substrat befinden. Die Arbeitsfrequenz fₒ beträgt ca. 800 MHz. Mit solch einem Resonator konnte das Rauschen des HTSL rf-SQUIDs drastisch reduziert werden.

Die Entwicklung von verbesserten SQUIDs und Schaltungen zur Minimierung des Rauschens und zur Stabilisierung des Arbeitspunktes nehmen einen immer wichtigeren Stellenwert ein.

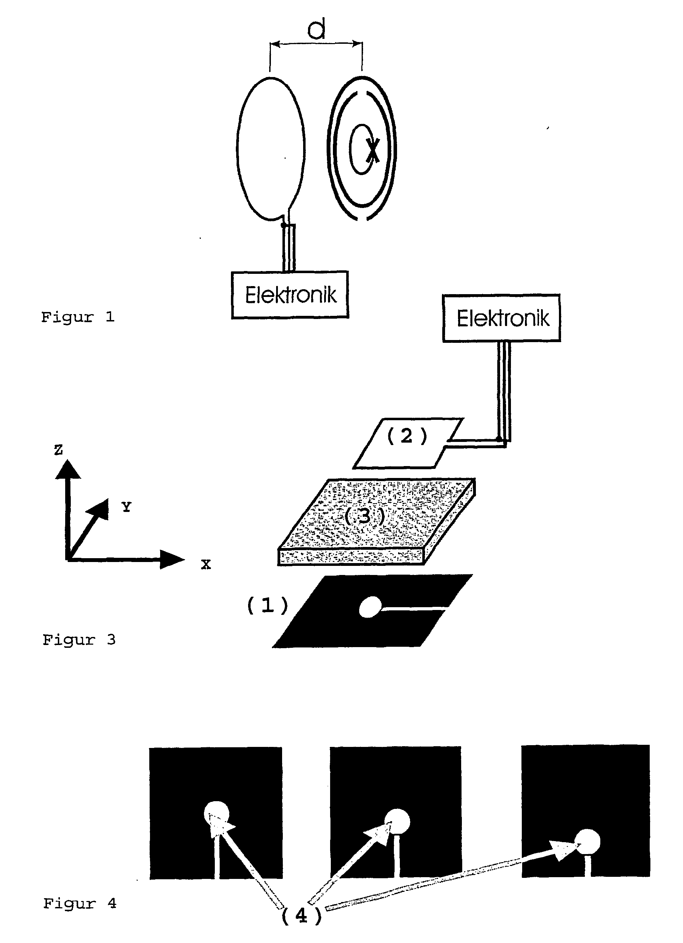

Nachteilig ist der rf-Arbeitspunkt des Koplanar-Resonator SQUIDs nicht sehr stabil, so daß ein zusätzliches Rauschen des SQUID-Systems im niedrigen Frequenzbereich verursacht wird. Wie in Figur 1 dargestellt, ist die Ausleseelektronik durch ein Kabel mit dem sogenannten Auslese-Loop verbunden. Ein durch den Auslese-Loop fließender rf-Strom wird zum Resonator und Washer-SQUID abgestrahlt. Das vom Resonator reflektierte SQUID Signal wird auch durch diesen Loop empfangen. Dabei wirken der Auslece-Loop und der Koplanar-Resonator wie zwei Dipole. Durch die Einstellung des Abstands d zwischen den zwei Dipolen kann der belastete Gütefaktor Q des Resonators so lange variiert werden, bis der optimale Wert von *k*²Q erreicht wird *(*Y. Zhang et al., Appl. Phys. Lett. 71 (5), 4 August 1997 *und* Y. Zhang et al., Applied Superconductivity Vol 6 (7-9), 1998, pp. 385-390*).*

Es hat sich gezeigt, daß nur sehr wenig der abgestrahlten rf-Energie zum SQUID gelangt und der größere Teil der rf-Energie in die Umgebung abgestrahlt wird. Dies bedeutet, jede Änderung der Umgebung wird den Arbeitspunkt des rf-SQUIDs regelmäßig beeinflussen. Bei dieser Konfiguration ist es daher sehr schwierig, den optimalen rf-Arbeitspunkt des SQUIDs zu definieren. Außerdem wird ein fachliches Wissen bei der Einstellung von diesem Abstand d gebraucht.

### Aufgabe und Lösung

Aufgabe der Erfindung ist es daher, eine über einen großen Frequenzbereich rauscharme Anordnung zum Messen magnetischer Flüsse zu schaffen.

Die Aufgabe wird gelöst durch eine Anordnung mit der Gesamtheit der Merkmale des Anspruchs 1. Vorteilhafte Ausgestaltungen ergeben sich aus den darauf rückbezogenen Ansprüchen.

### Gegenstand der Erfindung

Die erfindungsgemäße Anordnung zum Messen magnetischer Felder nach Anspruch 1 umfaßt einen Washer-SQUID oder einen SQUID mit einem single layer Flux-Transformator sowie einen Auslese-Loop. Weiterhin ist bei der Anordnung zwischen SQUID und Auslese-Loop ein Substrat angeordnet. Dieses Substrat bewirkt, daß beim Messen die rf-Energie, die vom Auslese-Loop zunächst abgestrahlt wird, in dem Substrat aufgenommen und direkt an den SQUID weitergegeben wird. Anders als es bei Stand der Technik üblich ist, wo ein Großteil der abgestrahlten rf-Energie in die Umgebung gelangt, wird so der größte Teil der Energie über das Substrat in den SQUID gekoppelt.

Dazu besteht das Substrat gemäß Anspruch 2 vorteilhaft aus einem Material, welches eine hohe Dielektrizitätskonstant ε aufweist. Unter hoch ist dabei ein ε größer als 100, insbesondere ε größer als 1000, zu verstehen. Ein Material mit einer hohen dieelektrischen Konstante vermag vorteilhaft die vom Auslese-Loop abgestrahlte rf-Energie aufzunehmen und zu speichern.

Ein Material, welches als Substrat geeignet ist und eine hohe Dielektrizitatskonstante aufweist, ist das SrTiO₃ mit einem ε von ca. 2000 bei 77 K. Zur besonders guten Kopplung von SQUID und Substrat grenzen nach Anspruch 4 beide direkt aneinander. Beispielsweise kann der SQUID durch Aufwachsen auf einem geeigneten Substrat hergestellt werden.

Die Kopplung zwischen dem Auslese-Loop und dem Substrat ist durch Einstellen eines Abstandes d in z-Richtung optimierbar. Insbesondere führt ein direktes Angrenzen (d=0) von Auslese-Loop und Substrat regelmäßig zu guten Kopplungsergebnissen.

Um einen möglichst großen Teil der vom Auslese-Loop abgestrahlten rf-Energie in dem Substrat zu speichern, ist es vorteilhaft, wenn die Fläche des Substrates in der x-y-Ebene möglichst groß ist. Insbesondere ist die Fläche mindestens so groß wie die vom SQUID eingenommene Fläche in x-y-Ebene und das Substrat derart angeordnet, daß der SQUID vollständig vom Substrat abgedeckt wird.

Da ein Bauteil jedoch auch möglichst kompakt ausgelegt werden soll, ist das Substrat bzw. seine Fläche in x-y-Ebene in einer vorteilhaften Ausführungsform nach Anspruch 7 geometrisch an die SQUID Fläche angepaßt.

Die Resonanzfrequenz fₒ des SQUIDs ist nicht nur von der Dimension und dem ε Wert des Substrates, sondern auch von den Randbedingungen abhängig. Das Strom-Maximum des Resonators (Substrat) liegt im Zentrum des Substrats in x-y-Ebene. Befindet sich der SQUID-Loop dort, erreicht man die maximale Koppelung *k²* zwischen dem Resonator und dem SQUID. Am Rand des substrats soll der Strom minimal (null) sein. Wenn der SQUID-Loop vom Zentrum zum Rand verlagert wird, reduziert sich der Wert der Koppelung *k²* vom Maximum zu Null. Dadurch kann ein Fachmann jederzeit den optimalen Wert von *k²*Q für verschiedene SQUID-Loop Größen ermitteln. SQUIDs mit kleinen SQUID-Loops werden vorteilhaft derart plaziert, daß sie, bezogen auf die x-y-Ebene der Substratfläche, im Zentrum des Substrats liegen, während SQUIDs mit größeren SQUID-Loops vorteilhaft zwischen dem Zentrum und dem Rand des Substrats plaziert werden.

Die erfindungsgemäße Anordnung weist ferner die folgenden besonderen Vorteile auf.
Für eine optimale rf-SQUID Anwendung müssen einige Anforderungen erfüllt sein. Dazu gehört, daß der SQUID mit einer hohen Arbeitsfrequenz fₒ betrieben werden kann, weil das Rauschen regelmäßig mit dem Verhältnis von 1/fₒ reduziert wird. Weiterhin ist vorteilhaft keine mechanische Einstellung für einen optimalen Wert von *k²*Q notwendig. Dadurch kann die erfindungsgemäße Anordnung nach einmaliger Einstellung auch von einem Nichtfachmann optimal so angewandt werden, daß ein deutlich reduziertes SQUID Rauschen erreicht wird. Ein weiterer Vorteil in der Anordnung liegt in dem sehr stabilen rf-Arbeitspunkt des SQUIDs, der regelmäßig nicht von der Umgebung abhängt.

Die erfindungsgemäße Anordnung erfüllt all diese Anforderungen und ist daher besonders geeignet kleine magnetische Flüsse empfindlich zu messen.

### Spezieller Ausführungsteil

Im weiteren wird der Gegenstand der Erfindung anhand von 5 Figuren und einem Ausführungsbeispiel näher erläutert. Es zeigen
- Figur 1:: Anordnung zum Messen magnetischer Flüsse gemäß Stand der Technik
- Figur 2:: Rauschen in Abhängigkeit von der Frequenz für die erfindungsgemäße Anordnung
- Figur 3:: Explosiv-Zeichnung einer Ausführungsform der erfindungsgemäßen Anordnung zum Messen magnetischer Flüsse
- Figur 4:: Beispiele für die vorteilhafte Lage verschiedener Loop-Größen eines SQUIDs bezogen auf die Substratfläche
- Figur 5:: Fluß-Spannung-Charakteristik des SQUIDs in einer Ausgestaltung der Erfindung.

Das Ausführungsbeispiel einer Anordnung zum Messen magnetischer Flüsse umfaßt einen herkömmlichen Auslese-Loop und einen YBCO Washer-SQUID. Das Substrat hat eine Größe von 10 x 10 x 1 mm und besteht aus SrTiO₃. SrTiO₃ ist ein ferroelektrisches Material mit einer Dielektrizitätskonstanten ε von ca. 2000 bei 77 K. Das Substrat kann als ein "zweidimensionaler Resonator" behandelt werden. Eine Seite des Substrats ist durch den Washer SQUID bedeckt. Der Auslese-Loop liegt direkt an der anderen Seite des Substrats (siehe Fig. 3). Diese Konfiguration ist ein quasi geschlossenes System. Die von dem Auslese-Loop ausgestrahlte rf-Energie wird wegen des hohen ε Wertes in das Substrat übertragen und darin gespeichert. In diesem Fall ist der Arbeitspunkt des SQUIDs viel stabiler als im Fall des Koplanar Resonators.

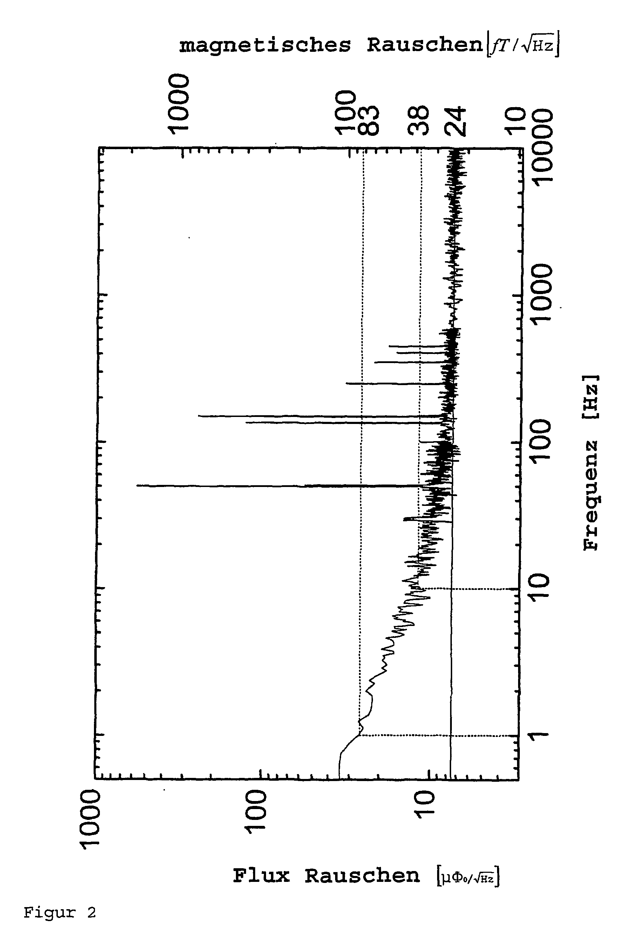

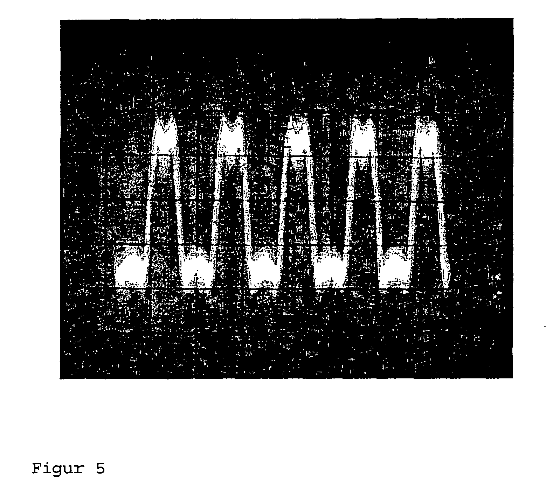

Für diese Ausführungsform betrug die gemessene Arbeitsfrequenz fₒ bei 77 K ca. 600 MHz. Der belastete Gütefaktor Q betrug ca. 200. Die Fluß-Spannung-Charakteristik des SQUIDs ist in Figur 5 dargestellt. Das Rauschspektrum des SQUID-Magnetometers bei 77 K ist in Figur 2 dargestellt. Bei diesen Messungen kam ein SQUID mit einer Loop-Größe von 100 x 100 µm² zum Einsatz, entsprechend einer SQUID-Induktivität von 150 PH. Das SQUID-Loop wurde im Zentrum des Substrats plaziert.

## Patentansprüche

1. Anordnung zum Messen magnetischer Felder, umfassend einen rf-Washer-SQUID (1) oder einen rf-SQUID mit einem single layer Flux-Transformator sowie einen Auslese-Loop (2),
**dadurch gekennzeichnet, dass** zwischen SQUID (1) und Auslese-Loop (2) ein Substrat (3) als zweidimensionaler Resonator angeordnet ist, zum Einkoppeln der rf-Energie in den SQUID.

2. Anordnung zum Messen magnetischer Felder nach vorhergehendem Anspruch 1,
**dadurch gekennzeichnet,**
**dass** das Substrat (3) bei 77 K eine Dieelektrizitätskonstante ε von mindestens 100, insbesondere von mehr als 1000 aufweist.

3. Anordnung zum Messen magnetischer Felder nach einem der vorhergehenden Ansprüche 1 bis 2,
**dadurch gekennzeichnet,**
**dass** als Substratmaterial SrTiO₃ vorgesehen ist.

4. Anordnung zum Messen magnetischer Felder nach einem der vorhergehenden Ansprüche 1 bis 3,
**dadurch gekennzeichnet,**
**dass** der SQUID (1) an das Substrat (3) angrenzt.

5. Anordnung zum Messen magnetischer Felder nach einem der vorhergehenden Ansprüche 1 bis 4,
**dadurch gekennzeichnet,**
**dass** der Auslese-Loop (2) an das Substrat (3) angrenzt.

6. Anordnung zum Messen magnetischer Felder nach einem der vorhergehenden Ansprüche 1 bis 5,
**dadurch gekennzeichnet,**
**dass** das substrat (3) die Fläche des SQUIDs (1) in x-y-Richtung vollständig abdeckt.

7. Anordnung zum Messen magnetischer Felder nach einem der vorhergehenden Ansprüche 1 bis 6,
**dadurch gekennzeichnet,**
**dass** der SQUID (1) und das Substrat (3) in x-y-Richtung geometrisch angepasst sind.

8. Anordnung zum Messen magnetischer Felder nach einem der vorhergehenden Ansprüche 1 bis 7,
**dadurch gekennzeichnet,**
**dass** der SQUID-Loop (4) in x-y-Richtung zwischen Rand und Zentrum des Substrates (3) angeordnet ist.

## Claims

1. Arrangement for measuring magnetic fields, comprising an rf washer SQUID (1) or an rf SQUID with a single layer flux transformer and a readout loop (2),
**characterised in that**
a substrate (3) is arranged between the SQUID (1) and readout loop (2) as a two-dimensional resonator for coupling the rf energy into the SQUID.

2. Arrangement for measuring magnetic fields according to the previous claim 1,
**characterised in that**
the substrate (3) has a dielectric constant ε of at least 100, particularly more than 1000, at 77 K.

3. Arrangement for measuring magnetic fields according to one of the previous claims 1 to 2,
**characterised in that**
SrTiO₃ is provided as the substrate material.

4. Arrangement for measuring magnetic fields according to one of the previous claims 1 to 3,
**characterised in that**
the SQUID (1) abuts the substrate (3).

5. Arrangement for measuring magnetic fields according to one of the previous claims 1 to 4,
**characterised in that**
the readout loop (2) abuts the substrate (3).

6. Arrangement for measuring magnetic fields according to one of the previous claims 1 to 5,
**characterised in that**
the substrate (3) covers the surface of the SQUID (1) completely in the x-y direction.

7. Arrangement for measuring magnetic fields according to one of the previous claims 1 to 6,
**characterised in that**
the SQUID (1) and the substrate (3) is adjusted geometrically in the x-y direction.

8. Arrangement for measuring magnetic fields according to one of the previous claims 1 to 7,
**characterised in that**
the SQUID loop (4) is arranged between the edge and the centre of the substrate (3) in the x-y direction.

## Revendications

1. Dispositif de mesure de champ magnétique, comprenant un rf-Washer-SQUID ( 1 ) ou un rf-SQUID ayant un transformateur de flux à couche unique ainsi qu'une boucle ( 2 ) de lecture,
**caractérisé**
**en ce qu'**entre le SQUID ( 1 ) et la boucle ( 2 ) de lecture est disposé, en tant que résonateur à deux dimensions, un substrat ( 3 ) pour injecter l'énergie rf dans le SQUID.

2. Dispositif de mesure de champ magnétique suivant la revendication 1 précédente,
**caractérisé**
**en ce que** le substrat ( 3 ) a à 77 K une constante ε diélectrique d'au moins 100, notamment de plus de 1000.

3. Dispositif de mesure de champ magnétique suivant l'une des revendications 1 à 2 précédentes,
**caractérisé**
**en ce qu'**il est prévu du SrTiO₃ comme matériau du substrat.

4. Dispositif de mesure de champ magnétique suivant l'une des revendications 1 à 3 précédentes,
**caractérisé**
**en ce que** le SQUID ( 1 ) est voisin du substrat ( 3 ).

5. Dispositif de mesure de champ magnétique suivant l'une des revendications 1 à 4 précédentes,
**caractérisé**
**en ce que** la boucle ( 2 ) de lecture est voisine du substrat ( 3 ).

6. Dispositif de mesure de champ magnétique suivant l'une des revendications 1 à 5 précédentes,
**caractérisé**
**en ce que** le substrat ( 3 ) recouvre complètement la surface du SQUID ( 1 ) dans la direction x-y.

7. Dispositif de mesure de champ magnétique suivant l'une des revendications 1 à 6 précédentes,
**caractérisé**
**en ce que** le SQUID ( 1 ) et le substrat ( 3 ) sont adaptés géométriquement dans la direction x-y.

8. Dispositif de mesure de champ magnétique suivant l'une des revendications 1 à 7 précédentes,
**caractérisé**
**en ce que** la boucle ( 4 ) de SQUID est disposée dans la direction x-y entre le bord et le centre du substrat ( 3 ).
